# FASCICULE DE BREVET EUROPEEN

(11) **EP 1 834 389 B1**
(45) Date de publication et mention de la délivrance du brevet: **17.07.2013**
(21) Numéro de dépôt: 05850473.9
(22) Date de dépôt: 21.12.2005
(51) Int. Cl.: H01S 5/10, H01S 5/20

(54) **LASER A SEMICONDUCTEUR STABLE EN TEMPERATURE ET A FAISCEAU HOMOGENE ET PROCEDE DE REALISATION**
TEMPERATURSTABILER HALBLEITERLASER MIT HOMOGENEM STRAHL UND HERSTELLUNGSVERFAHREN
HOMOGENEOUS-BEAM TEMPERATURE-STABLE SEMICONDUCTOR LASER AND METHOD OF PRODUCTION

(30) Priorité: 22.12.2004 FR 0413742
(43) Date de publication de la demande: 19.09.2007
(73) Titulaire: Thales, 92200 Neuilly Sur Seine (FR)
(72) Inventeur: KRAKOWSKI, Michel, F-92340 Bourg La Reine (FR)
(74) Mandataire: Henriot, Marie-Pierre
(86) Numéro de dépôt international: PCT/EP2005/057005
(87) Numéro de publication internationale: WO 2006/067167

(56) Documents cités:
- US-B1- 6 272 162
- BORRUEL L; SUJECKI S; MORENO P; WYKES J; SEWELL P; BENSON T: "Modeling of patterned contacts in tapered lasers" IEEE JOURNAL OF QUANTUM ELECTRONICS, vol. 40, no. 10, octobre 2004 (2004-10), pages 1384-1388, XP002378729
- GERARD F ET AL: "SINGLE TRANSVERSE-MODE FILTERING UTILIZING ION IMPLANTATION: APPLICATION TO 1.48-MUM UNSTABLE-CAVITY LASERS" IEEE PHOTONICS TECHNOLOGY LETTERS, IEEE SERVICE CENTER, PISCATAWAY, NJ, US, vol. 12, no. 11, novembre 2000 (2000-11), pages 1447-1449, XP000981059 ISSN: 1041-1135

## Description

La présente invention se rapporte à un laser à semi-conducteur stable en température et à faisceau homogène, ainsi qu'à un procédé de réalisation d'un tel laser.

Les lasers à semi-conducteur de puissance supérieure à 1 Watt sont généralement des lasers de type à ruban large et, en fonction de la puissance d'émission requise, peuvent être unitaires ou disposés en parallèle pour former des barrettes. Le principal inconvénient de tels lasers est que la distribution en amplitude de leur faisceau émis, dans un plan perpendiculaire à leur face d'émission, est fortement divergente (divergence de l'ordre de 15° dans un plan parallèle aux couches actives) et très inhomogène, ce qui entraîne une baisse de rendement du couplage à une fibre optique. La cause en est l'existence de modes parasites dans la cavité du laser et la présence de phénomènes de « filamentation » (le courant électronique, à l'intérieur du semi-conducteur, passe non pas par toute la section active du semi-conducteur, mais par un point de cette section).

Pour améliorer l'homogénéité du champ proche de la face d'émission de tels lasers, on a intégré sur la même puce un laser à ruban étroit monomode (agissant comme un filtre) prolongé par une partie évasée agissant en amplificateur. On peut alors émettre des puissances nettement supérieures à 1 Watt, tout en gardant un faisceau transverse monomode. Les lasers connus ont été réalisés selon les deux configurations suivantes. La première consiste à graver dans des couches actives un ruban étroit monomode à guidage transverse par l'indice suivi d'une partie évasée qui est également à guidage transverse par l'indice, « guidage transverse par l'indice » signifiant que le confinement latéral du champ optique est obtenu par une différenciation de l'indice de réfraction entre la zone du ruban étroit et les zones qui la bordent. La seconde configuration comporte également un ruban étroit monomode à guidage transverse par l'indice, mais suivi d'une partie évasée à guidage transverse par le gain. Jusqu'à présent, aucune autre configuration n'a été proposée, car on estimait que seules les deux précitées permettaient de contrôler facilement la qualité du faisceau laser émis. Cependant, ces structures connues sont relativement complexes à réaliser et leur dissipation thermique n'est pas facile à évacuer.

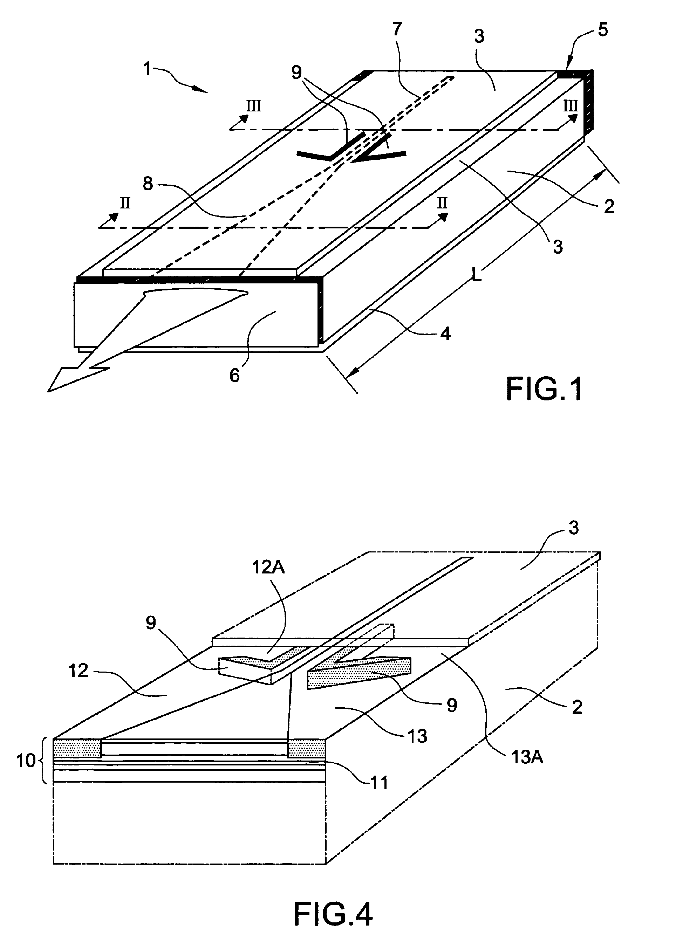

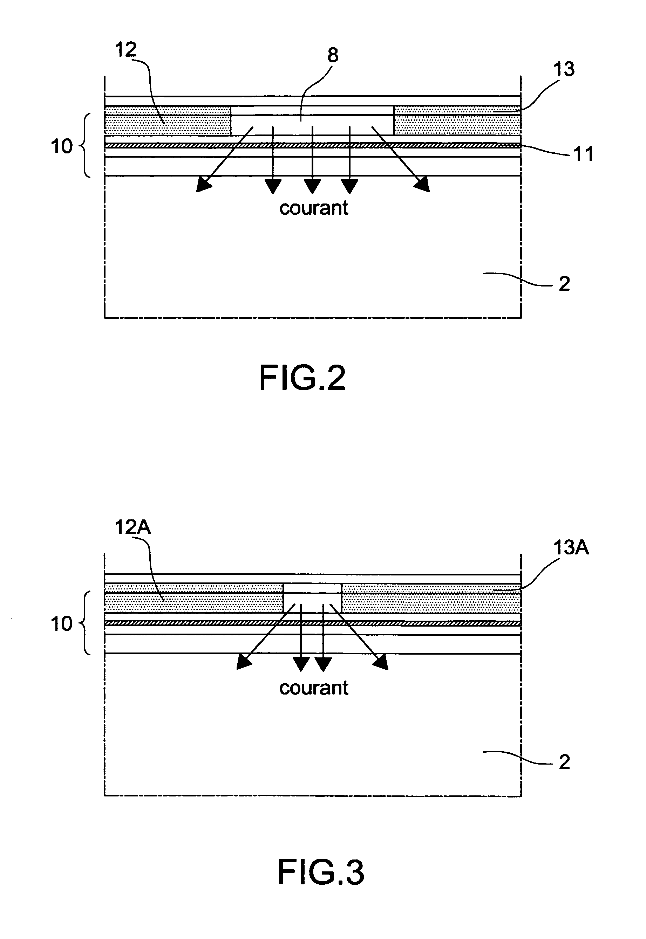

On connaît d'après le brevet US 6 272 162 un laser semi-conducteur comportant une première partie sous forme d'un ruban étroit et une deuxième partie terminale évasée. Outre le fait que ce laser connu comporte entre ces deux parties des « bandes de pompage » séparées par des zones à haute résistance, le ruban étroit est déposé après avoir creusé des couches actives par attaque chimique, alors que la partie évasée est délimitée par implantation ionique dans les zones qui la bordent. Il en résulte un procédé de fabrication complexe, long et coûteux. Des lasers présentant de tels inconvénients sont également connus d'après les documents suivants :
- Borruel L, Sujecki S, Moreno P, Wykes J, Sewell P, Benson T : »Modeling of patterned contacts in tapered lasers» IEEE JOURNAL OF QUANTUM ELECTRONICS, Vol 40 N° 10, octobre 2004 (2004-10), pages 1384-1388, XP002378729 parties I est II, figures 1,2
- Gerard F et al: "Single transverse-mode filtering utilizing ion implantation ; application to 1.48-MUM unstable-cavity lasers», IEEE PHOTONICS TECHNOLOGY LETTERS, IEEE Service center, Piscataway, NJ, US, vol 12, N° 11, novembre 2000 (2000-11), pages 1447-1449, XP000981059, ISSN: 1041-1135, parties I est II, figures 1,2.

La présente invention a pour objet un laser à semi-conducteur dont le faisceau émis ait une faible divergence, soit homogène, et ait une puissance supérieure à environ 1 W tout en étant stable en température, qui soit facile à réaliser, qui puisse avoir une bonne dissipation thermique et qui puisse être fabriqué par groupes de plusieurs éléments sur le même substrat.

Le laser conforme à l'invention, du type à semi-conducteur, est caractérisé en ce qu'il comporte, dans les couches se trouvant au-dessus du puits quantique, une première partie sous forme de ruban étroit monomode à guidage transverse par le gain, terminée par une deuxième partie s'évasant depuis la première partie, également à guidage transverse par le gain.

Le procédé de l'invention est un procédé de réalisation d'un laser du type à semi-conducteur, comportant une première partie sous forme d'un ruban étroit et se prolongeant par une deuxième partie s'évasant à partir de la première partie, et il est caractérisé en ce qu'il comporte les étapes suivantes
- croissance épitaxiale du substrat et des couches actives et de confinement suivantes, ainsi que d'une couche supérieure de contact électrique,
- dépôt d'un contact ohmique sur la couche supérieure de contact électrique,
- amincissement de la face inférieure du substrat,
- dépôt d'un contact ohmique sur la face inférieure du substrat, dépôt d'un photorésist sur le contact ohmique et photolithographie en laissant subsister du photorésist au-dessus d'une zone correspondant auxdites deux parties du laser,
- implantation de protons par la face supérieure de l'ensemble du substrat et des couches formées sur lui,
- dépôt d'une électrode sur le contact ohmique.

La présente invention sera mieux comprise à la lecture de la description détaillée d'un mode de réalisation, pris à titre d'exemple non limitatif et illustré par le dessin annexé, sur lequel :
- la figure 1 est une vue simplifiée en perspective d'un laser conforme à l'invention,
- la figure 2 est une vue en coupe, selon II-II de la figure 1, de la partie évasée du laser de la figure 1 à laquelle est associé un diagramme de l'évolution de l'indice optique le long de cette section,
- la figure 3 est une vue en coupe, selon III-III de la figure 1, de la partie étroite du laser de la figure 1 à laquelle est associé un diagramme de l'évolution de l'indice optique le long de cette section,
- la figure 4 est une vue simplifiée en perspective, avec un arraché montrant un détail de réalisation d'un déflecteur du laser de la figure 1,
- la figure 5 est une vue en coupe schématique montrant les différentes couches de confinement et actives du laser de la figure 1, et
- la figure 6 est un ensemble de neuf vues en coupe très simplifiées montrant les différentes étapes de fabrication du laser de l'invention.

Le laser semi-conducteur 1 représenté en figure 1 est une source laser élémentaire, mais il est bien entendu que l'on peut constituer une barrette comportant plusieurs telles sources élémentaires côte à côte, formées dans le même barreau semi-conducteur. Le laser 1 se présente sous forme d'un barreau 2 semi-conducteur en forme de parallélépipède rectangle. Sur les deux grandes faces du barreau 2, on forme des électrodes 3 et 4. L'une des deux plus petites faces latérales, référencée 5, est traitée de façon à présenter une très haute réflectivité aux longueurs d'onde de fonctionnement du laser. L'autre plus petite face latérale, référencée 6, qui est la face émissive du laser, est traitée anti-reflets. Dans les couches de guidage transversal du barreau 2 (décrites en détail ci-dessous), on forme, parallèlement au grand axe du barreau 2, un « canal de passage de courant » ou ruban étroit monomode 7 qui se prolonge par un évasement 8 aboutissant à la face 6. L'angle d'ouverture de la partie 8 est d'environ 1 à 2 degrés. La largeur du ruban 7 est de quelques microns. Selon un premier exemple de réalisation, la longueur L du barreau est d'environ 2,5 à 3 mm, l'angle d'ouverture de la partie 8 est d'environ 2° et sa longueur est d'environ 1 mm. Selon un autre exemple de réalisation, la longueur L est également d'environ 2,5 à 3 mm, l'angle d'ouverture de la partie 8 est d'environ 0,64° et sa longueur est d'environ 2,2 mm. En fait, ce ruban 7 et son prolongement évasé 8 ne sont pas matérialisés, mais correspondent à des zones conductrices de la région active du barreau 2 dans l'axe desquelles le gain optique, représenté par la partie imaginaire de l'indice de réfraction de cette région active, est maximal, alors que la partie réelle de cet indice est minimale. La façon de réaliser ces zones est décrite ci-dessous. En outre, afin d'éviter les effets parasites sur le flux laser des photons s'échappant de la partie évasée 8, on forme autour du ruban 7 un réflecteur 9, près de sa jonction avec la partie évasée 8. Ce réflecteur 9 se compose de deux éléments disposés symétriquement de part et d'autre du ruban 7. Chacun de ces deux éléments a une forme de « V » dont une branche est parallèle au ruban 7 et dont l'autre branche fait un angle inférieur à 90° par rapport à la première.

Selon une variante de l'invention (non représentée), l'axe de la partie évasée 8 peut ne pas être aligné sur l'axe du ruban 7, mais faire avec celui-ci un angle de quelques degrés (dans un plan parallèle à celui des couches actives), afin de diminuer la réflectivité de la face de sortie du faisceau laser.

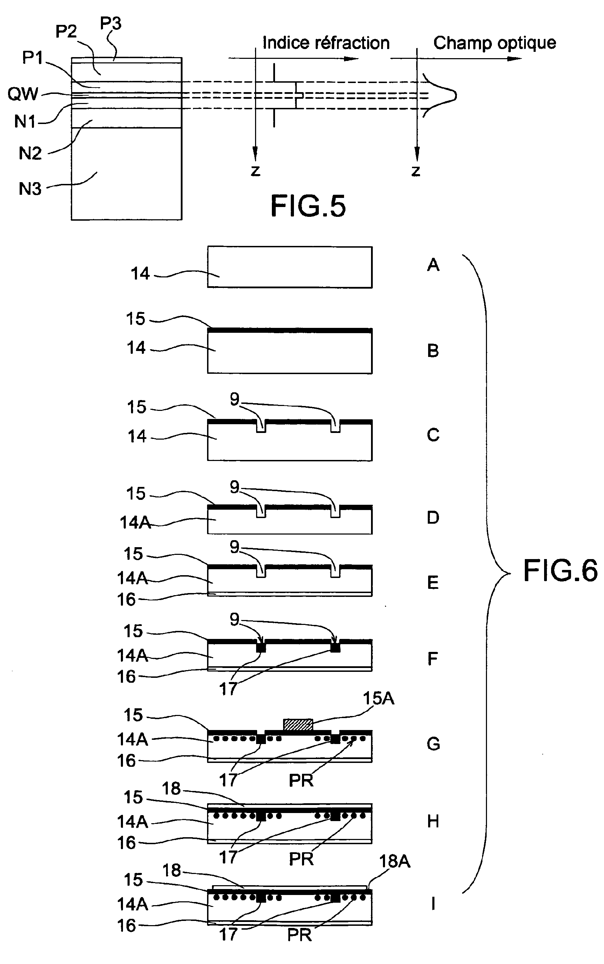

On a représenté en figure 2 une vue en coupe schématique des couches actives de guidage transversal de la partie évasée 8. Ces couches sont référencées 10 dans leur ensemble, et elles enserrent au moins un puits quantique 11. Un exemple de réalisation est détaillé ci-dessous en référence à la figure 5. Le matériau de ces couches actives est conservé dans tout leur volume (autrement dit, il n'y a pas d'enlèvement de ce matériau). La réalisation de la partie évasée 8 se fait par implantation de protons dans les zones extérieures à cette partie évasée que l'on veut obtenir (zones référencées 12 et 13 en figure 2, de part et d'autre de la partie 8), dans les couches se trouvant au-dessus du puits quantique 11, rendant électriquement isolantes ces zones extérieures, alors que la partie centrale, correspondant à la partie évasée, reste conductrice. Si on détermine l'évolution de la densité de courant dans une direction perpendiculaire à l'axe de la partie évasée 8, on remarque que cette évolution a sensiblement une allure gaussienne, avec un maximum au niveau du centre de la partie 8 et est pratiquement nulle dans les zones 12 et 13.

On a représenté en figure 3 une vue en coupe schématique des couches actives de guidage transversal du ruban 7. Ces couches sont les mêmes que celles de la figure 2 et sont référencées 10 dans leur ensemble, et elles enserrent au moins un puits quantique 11. Comme dans le cas de la figure 2, le matériau de ces couches actives est conservé dans tout leur volume. La réalisation du ruban 7 se fait également par implantation de protons dans les zones extérieures à ce ruban que l'on veut obtenir (zones référencées 12A et 13A en figure 3, de part et d'autre du ruban 7), dans les couches se trouvant au-dessus du puits quantique 11, rendant électriquement isolantes ces zones extérieures, alors que la partie centrale, correspondant au ruban, reste conductrice. L'énergie de ces protons peut être d'environ au moins 100keV. Si on détermine l'évolution de la densité de courant dans une direction perpendiculaire à l'axe du ruban 7, on constate qu'elle a sensiblement une allure gaussienne, avec un maximum au niveau du centre de la partie 7 et est pratiquement nulle dans les zones 12A et 13A.

Sur le schéma de la figure 4, on a représenté en particulier les détails de réalisation du réflecteur 9. Les deux « V » de ce réflecteur sont réalisés en creusant dans les couches actives 10 se trouvant au-dessus du puits quantique 11 des « tranchées » à parois perpendiculaires aux plans de ces couches et dont la section, dans un plan parallèle au plan des couches a la forme en « V » décrite ci-dessus. Ces tranchées sont ensuite remplies d'une matière polymère, ce qui les rend électriquement isolantes.

On a schématiquement représenté en figure 5 la structure semi-conductrice du laser de l'invention. Cette structure est formée sur un substrat N3 de type N fortement dopé, par exemple en GaAs. Sur ce substrat, on forme successivement les couches suivantes :
- Une couche N2 de confinement optique et électrique, de type N, à faible indice. Elle peut être en GalnP, GaAlAs, AlGalnP, etc.
- Une couche N1 de confinement électrique et optique, de type N, à fort indice. Elle peut être en GalnAsP, GalnP, etc.
- Une couche QW, qui est une couche active à puits quantique.
- Une couche P1 de confinement électrique et optique de type P, à indice fort. Elle peut être en GalnAsP, GalnP, etc.
- Une couche P2 de confinement optique de type P, à faible indice. Elle peut être en GalnP, GaAlAs, AlGalnP, etc.
- Une couche P3 de contact électrique de type P, fortement dopée, par exemple en GaAs.

En correspondance avec le schéma de la structure qui vient d'être décrite, on a représenté, sur la figure 5, à droite de cette structure, la courbe d'évolution de l'indice de réfraction des différentes couches qui la composent, ainsi que la courbe d'évolution de l'intensité du champ optique, le long d'une direction perpendiculaire aux plans de ces couches.

En figure 6, on a schématiquement représenté les neuf premières étapes de réalisation de la structure du laser de l'invention, référencées A à I, parmi les douze principales. Ces étapes sont, dans l'ordre :
- (A) : croissance épitaxiale du substrat et des couches suivantes, telles que celles représentées en figure 5, l'ensemble étant référencé 14,
- (B) : dépôt d'un contact ohmique 15 sur la couche P3 de la structure 14,
- (C) : photolithographie et gravure des deux « V » du réflecteur 9,
- (D) : amincissement du substrat (du côté de la face opposée à la couche 15), l'ensemble de la structure semi-conductrice est maintenant référencé 14A,
- (E) : dépôt d'un contact ohmique 16 sur la face inférieure du substrat,
- (F) : dépôt de polymère 17 dans les tranchées du réflecteur 9, puis élimination du surplus afin d'obtenir une surface plane, coplanaire avec la face supérieure du dépôt 15,
- (G) : photolithographie sur la face supérieure de la couche 15, puis implantation de protons (symbolisés par un ensemble de points PR) afin de définir les parties 7 et 8. La zone se trouvant sous la partie 15A de photorésist subsistant après photolithographie (entre les deux tranchées 9) ne comporte pas de protons,
- (H) : dépôt d'une électrode 18 sur la couche 15,
- (I) : photolithographie sur l'électrode et ouverture par attaque chimique des chemins de découpe 18A entre lasers unitaires adjacents ou groupes adjacents de lasers élémentaires,
- clivage des faces 5 et 6,
- traitement anti-reflets des faces d'émission laser 6,
- traitement haute réflectivité des faces 5,
- séparation des lasers élémentaires (ou des barrettes de lasers élémentaires), en suivant les chemins de découpe 18A.

Ainsi, grâce à l'invention, il est possible de réaliser des sources laser élémentaires ou groupées en barrettes, et de les fixer par leur face supérieure (celle 18) sur un radiateur thermique approprié, ce qui améliore nettement l'évacuation thermique en fonctionnement par rapport aux sources de l'art antérieur, qui ne pouvaient être fixées sur un radiateur que par leur embase.

Selon des exemples de réalisation de l'invention, on a obtenu des lasers élémentaires ayant de longueurs d'onde comprises entre 0,7 et 1,1 µm avec des puits ou boites (dites « Qdots ») quantiques sur substrat en GaAs, des longueurs d'onde comprises entre 1,1 et 1,8 µm avec des puits ou boites quantiques sur substrat en InP, des longueurs d'onde comprises entre 2 et 2,5 µm pour des puits ou boites quantiques sur substrat en GaSb, et des longueurs d'onde comprises entre 3 et plus de 12 µm avec des sources laser de type QCL.

En général, pour tous ces exemples de réalisation, la divergence du faisceau émis était de l'ordre de quelques degrés, et la puissance du faisceau dans le ruban de l'ordre de 200 à 300 mW, et à la sortie de la partie évasée supérieure à 10 W.

Selon un exemple de réalisation, on a fabriqué sur une structure semi-conductrice émettant autour de λ = 975 nm un laser du type décrit ci-dessus, d'une longueur totale de 3 mm. Il était pourvu d'une couche de haute réflectivité en face arrière, et d'une couche de faible réflectivité en face avant. La puissance de sortie du laser a atteint 2 W en régime continu à 20°C. La « puce » formée par ce laser présentait un courant de seuil de seulement 263 mA, et un bon rendement externe différentiel de 0,72 W/A. Son rendement à la prise atteignait son maximum de 43% vers 1,5 W, ce qui est une bonne valeur pour un laser évasé à semi-conducteur. Ces bons résultats étaient conservés entre 15 et 25°C. Le champ lointain de ce laser a été mesuré à environ 20 cm du laser. Le faisceau émis était très étroit : sa largeur valait entre 1° et 2° à mi-hauteur et 2° et 5° à 1/e². Le profil du champ lointain présentait un pic très net. On sait que le courant seuil des lasers à semi-conducteurs varie comme exp(T/T₀). On a mesuré la température caractéristique T₀ du laser ainsi réalisé, et elle valait 136 K entre 20 et 40°C. Cette grande valeur indique que le seuil du laser augmente très peu avec la température.

## Revendications

1. Laser du type à semi-conducteur (1) comportant sur un substrat des couches actives dont au moins une couche à puits quantique (11) ou à boîtes quantiques, une première partie sous forme de ruban (7) étroit monomode se prolongeant directement par une deuxième partie (8) s'évasant depuis la première partie, carctérisé en ce que ces deux parties sont délimitées sans enlèvement de matériau dans les couches situées au-dessus de la couche ou des couches à puits quantique ou à boîtes quantiques, par une implantation de protons (PR) dans les zones qui les bordent (12-13, 12A-13A), de manière à obtenir une première et une deuxième partie à guidage transverse par le gain.

2. Laser selon la revendication 1, **caractérisé en ce qu'**il comporte au niveau de la première partie de cavité, un déflecteur de photons parasites (9).

3. Laser selon la revendication 2, **caractérisé en ce que** le déflecteur comporte deux tranchées (9) en forme de « V » disposées de part et d'autre de la première partie de cavité, et que ces tranchées sont remplies de matériau isolant (17).

4. Laser selon l'une des revendications précédentes, **caractérisé en ce qu'**il est fixé sur un radiateur thermique par sa face opposée au substrat (18).

5. Procédé de réalisation d'un laser du type à semi-conducteur comportant sur un substrat des couches actives dont au moins une couche à puits quantique (11) ou à boîtes quantiques, comportant une première partie sous forme d'un ruban étroit et se prolongeant par une deuxième partie s'évasant à partir de la première partie, qui comporte les étapes suivantes :
- croissance épitaxiale du substrat et des couches actives et de confinement suivantes (14), ainsi que d'une couche supérieure de contact électrique (P3),
- dépôt d'un contact ohmique (15) sur la couche supérieure de contact électrique,
- amincissement de la face inférieure du substrat,
- dépôt d'un contact ohmique (16) sur la face inférieure du substrat,
- dépôt d'un photorésist sur le contact ohmique et photolithographie en laissant subsister du photorésist (15A) au-dessus d'une zone correspondant auxdites deux parties du laser,
- implantation de protons par la face supérieure de l'ensemble du substrat et des couches formées sur lui, dans les couches situées au-dessus de la couche ou des couches à puits quantique ou à boîtes quantiques dans des zones extérieures aux deux parties, délimitant ainsi les deux parties sans enlèvement de matériau des couches situées au dessus de la couche ou des couches à puits quantique ou à boites quantiques,
- dépôt d'une électrode sur le contact ohmique.

6. Procédé selon la revendication 5, **caractérisé en ce que** l'on réalise plusieurs lasers unitaires sur un même substrat, que l'on dépose une électrode sur l'ensemble des lasers unitaires, que l'on trace par photolithographie sur cette électrode des chemins de découpe (18A) délimitant les lasers unitaires, que l'on ouvre ces chemins par attaque chimique dans cette électrode, et que l'on sépare les lasers élémentaires en suivant les chemins de découpe.

## Patentansprüche

1. Laser (1) des Halbleitertyps, der auf einem Substrat aktive Schichten, darunter wenigstens eine Schicht mit Quantentöpfen (11) oder Quantenboxen umfasst, wobei ein erster Teil in Form eines schmalen Monomodenstreifens (7) direkt zu einem zweiten Teil (8) verläuft, der sich vom ersten Teil aufweitet, **dadurch gekennzeichnet, dass** diese beiden Teile ohne Entfernen von Material in den Schichten, die sich über der Schicht oder den Schichten mit Quantentöpfen oder Quantenboxen befinden, durch eine Implantation von Protonen (PR) in den an sie angrenzenden Zonen (12-13, 12A-13A) begrenzt werden, um einen ersten und einen zweiten Teil mit transversaler Führung durch die Verstärkung zu erhalten.

2. Laser nach Anspruch 1, **dadurch gekennzeichnet, dass** er am ersten Hohlraumteil einen Deflektor für parasitäre Photonen (9) umfasst.

3. Laser nach Anspruch 2, **dadurch gekennzeichnet, dass** der Deflektor zwei "V"-förmige Einschnitte (9) jeweils auf beiden Seiten des ersten Hohlraumteils aufweist, und dadurch, dass die Einschnitte mit Isoliermaterial (17) gefüllt sind.

4. Laser nach einem der vorherigen Ansprüche, **dadurch gekennzeichnet, dass** er mit seiner Fläche gegenüber dem Substrat (18) an einem Wärmestrahler befestigt ist.

5. Verfahren zum Erzeugen eines Lasers des Halbleitertyps, der auf einem Substrat aktive Schichten, darunter wenigstens eine Schicht mit Quantentöpfen (11) oder Quantenboxen umfasst, umfassend einen ersten Teil in Form eines schmalen Streifens, der zu einem zweiten Teil verläuft, der sich vom ersten Teil aufweitet, wobei das Verfahren die folgenden Schritte beinhaltet:
- epitaxiales Wachsenlassen des Substrats und der nachfolgenden aktiven und Einschlussschichten (14) sowie einer oberen elektrischen Kontaktschicht (P3),
- Absetzen eines ohmschen Kontakts (15) auf die obere elektrische Kontaktschicht,
- Verdünnen der Unterseite des Substrats,
- Absetzen eines ohmschen Kontakts (16) auf die Unterseite des Substrats,
- Absetzen eines Fotolacks auf den ohmschen Kontakt und Fotolithografieren, so dass der Fotolack (15A) über einer Zone bleibt, die den zwei Teilen des Lasers entspricht,
- Implantieren von Protonen durch die Oberseite der Substratbaugruppe und der darauf ausgebildeten Schichten in den Schichten, die sich über der/den Schicht(en) mit Quantentöpfen oder Quantenboxen in den Zonen außerhalb der beiden Teile befinden, so dass die beiden Teile begrenzt werden, ohne Material von den Schichten zu entfernen, die sich über der/den Schicht(en) mit Quantentöpfen oder Quantenboxen befinden,
- Absetzen einer Elektrode auf den ohmschen Kontakt.

6. Verfahren nach Anspruch 5, **dadurch gekennzeichnet, dass** mehrere unitäre Laser auf demselben Substrat erzeugt werden, dass eine Elektrode auf alle unitären Laser abgesetzt wird, dass auf dieser Elektrode die unitären Laser begrenzende Schnittwege (18A) fotolithografisch gezeichnet werden, dass diese Wege durch chemisches Ätzen dieser Elektrode geöffnet und die Elementarlaser durch Verfolgen der Schnittwege getrennt werden.

## Claims

1. A laser (1) of the semi-conductor type comprising, on a substrate, active layers including at least one quantum well (11) or quantum box layer, a first part in the form of a narrow monomode strip (7) directly extending to a second part (8) flaring out from said first part, **characterised in that** these two parts are delimited, without the removal of material from the layers located above the layer or layers of quantum wells or quantum boxes, by the implantation of protons (PR) in the zones bordering them (12-13, 12A-13A), so as to obtain a first and a second part with transverse gain-guiding.

2. The laser according to claim 1, **characterised in that** it comprises a parasitic photon deflector (9) at the first cavity part.

3. The laser according to claim 2, **characterised in that** said deflector comprises two "V" shaped cuts (9) disposed either side of the first cavity part, and **in that** said cuts are filled with insulating material (17).

4. The laser according to any one of the preceding claims, **characterised in that** it is fixed to a thermal radiator by its face opposite the substrate (18).

5. A method for producing a laser of the semi-conductor type comprising, on a substrate, active layers including at least one quantum well (11) or quantum box layer, comprising a first part in the form of a narrow strip and extending to a second part flaring out from said first part, which method comprises the following steps:
- epitaxially growing the substrate and the subsequent active and containment layers (14), as well as an upper electric contact layer (P3),
- depositing an ohmic contact (15) on the upper electric contact layer,
- thinning the lower face of the substrate,
- depositing an ohmic contact (16) on the lower face of the substrate,
- depositing a photoresist on the ohmic contact and photolithography allowing said photoresist (15A) to remain above a zone corresponding to said two parts of the laser,
- implanting protons, via the upper face of the substrate assembly and the layers formed thereon, in the layers located above the layer or layers of quantum wells or quantum boxes in the zones outside of the two parts, thus delimiting the two parts without removing material from the layers located above the layer or layers of quantum wells or quantum boxes,
- depositing an electrode on the ohmic contact.

6. The method according to claim 5, **characterised in that** a plurality of unitary lasers is produced on the same substrate, that an electrode is deposited on all of the unitary lasers, that cutting paths (18A) are traced by photolithography on said electrode thus delimiting the unitary lasers, that these paths are opened by etching in this electrode, and that the elementary lasers are separated by following the cutting paths.
